# EUROPÄISCHE PATENTSCHRIFT

(11) **EP 0 518 100 B1**
(45) Veröffentlichungstag und Bekanntmachung des Hinweises auf die Patenterteilung: **02.10.1996**
(21) Anmeldenummer: 92108663.3
(22) Anmeldetag: 22.05.1992
(51) Int. Cl.: G01R 33/28

(54) **Stellantrieb**
Servo drive
Servo-entraînement

(30) Priorität: 14.06.1991 DE 4119674
(43) Veröffentlichungstag der Anmeldung: 16.12.1992
(73) Patentinhaber: SPECTROSPIN AG, CH-8117 Fällanden (CH)
(72) Erfinder: Rindlisbacher,Martin, CH-8053 Zürich (CH); Berther,Jürg, CH-8003 Zürich (CH)
(74) Vertreter: KOHLER SCHMID + PARTNER

(56) Entgegenhaltungen:
- EP-A- 0 164 801
- DE-A- 3 639 140
- FR-A- 2 583 172
- US-A- 4 783 629
- US-A- 4 944 501
- US-A- 5 041 788
- REVIEW OF SCIENTIFIC INSTRUMENTS. Bd. 38, Nr. 12, 1. Dezember 1967, NEW YORK US Seiten 1810 - 1812; J.C. ABELE ET AL.: 'LOW TEMPERATURE SAMPLE HOLDER PROVIDING TWO DEGREES OF ROTATIONAL FREEDOM'

## Beschreibung

Die Erfindung betrifft einen Stellantrieb, der zum Verstellen einer Mehrzahl von Stellgliedern in einem Kernresonanzspektrometer bestimmt ist. Derartige Stellglieder können insbesondere bei einem NMR-Probenkopf für die Aufnahme von Kernresonanzspektren unterschiedlicher Kernarten vorhanden sein und dienen dort zum Abstimmen der Frequenz und zur Einstellung der Impedanz-Anpassung. Hierzu sind bei bekannten Probenköpfen beispielsweise zur Einstellung des Werts eines Kondensators für die Frequenzabstimmung vier Schiebestangen vorgesehen, die je nach ihrer Schiebestellung Kondensatoren mit unterschiedlichen Werten einschalten. Der Wert der wirksamen Kapazität kann dabei im allgemeinen an einer Skala an den Stangen nach dem Dezimalsystem abgelesen werden. Ein Probenkopf kann zusätzlich oder ausschließlich drehbare Stellglieder zur Abstimmung und Anpassung aufweisen. Eine Änderung der Abstimmung und/oder Impedanz-Anpassung ist beispielsweise erforderlich, wenn das Kernsignal einer anderen Kernart aufgenommen werden soll, wenn die Probe gewechselt wird, oder bei Temperaturänderungen.

Es sind Verfahren bekannt, um die Frequenzeinstellung und Impedanz-Anpassung relativ rasch vorzunehmen. Bei einem aus der DE-A1-38 38 252 bekannten Verfahren wird beispielsweise an einem mit dem Probenkopf verbundenen Vorverstärker im Wechsel der Probenkopf und ein Referenzwiderstand angeschlossen, und durch Vergleich von dabei ermittelten Meßwerten wird die Abweichung des augenblicklichen komplexen Widerstands des Probenkopfes von dem durch den Referenzwiderstand gegebenen Soll-Zustand ermittelt und dem Benutzer dadurch ein Hinweis darauf gegeben, wie er die Abstimmelemente und Anpaßelemente verstellen muß. Das Verstellen selbst ist deshalb, weil sich die Vorrichtung, an der die jeweilige Fehlanpassung und Abweichung der Eigenfrequenz des Probenkopfes abgelesen werden kann, in einem Abstand vom Probenkopf befindet, nämlich am Bedienerpult des Kernresonanz-Spektrometers, wogegen sich der Probenkopf im Inneren des Magneten des Kernresonanzspektrometers befindet, umständlich und zeitaufwendig, weil der Bediener häufig zwischen dem Bedienerpult und dem Probenkopf hin- und hergehen muß. Die Betätigung von Stellgliedern zwecks Einstellung der Frequenz und/oder Anpassung kann bei einem Kernresonanzspektrometer auch an anderer Stelle erforderlich sein, beispielsweise wenn elektrische Filterschaltungen, die einstellbar sind, abgestimmt werden müssen.

Ein Stellglied gemäß dem Oberbegriff des Anspruchs 1 ist aus US-A-4 783 629 bekannt.

Um die geschilderten Einstellvorgänge zu vereinfachen, sieht die Erfindung einen Stellantrieb für die genannten Stellglieder vor, der in einfacheren Fällen vom Benutzer, der an seinem Bedienerpult sitzt, fernbetätigbar ist, der es aber insbesondere auch ermöglichen soll, durch eine Fernbetätigung mit Hilfe eines Computers, wie er bei Kernresonanzspektrometern immer vorhanden ist, die Einstellung und Anpassung automatisch vorzunehmen. Durch eine derartige automatische Frequenzeinstellung und Anpassung wird es insbesondere ermöglicht, im Zusammenwirken mit automatischen Probenwechselvorrichtungen einen unbeaufsichtigten Betrieb des Kernresonanzspektrometers, z. B. während der Nachtstunden oder des Wochenendes durchzuführen.

Der erfindungsgemäße Stellantrieb dient zum steuerbaren Verstellen einer Mehrzahl von Stellgliedern in einem Kernresonanzspektrometer, wobei der Stellantrieb ein Getriebe mit einer durch einen elektrischen Antriebsmotor antreibbaren Antriebswelle und mit einer Mehrzahl von mit den Stellgliedern zu koppelnden Getriebeausgängen aufweist und dadurch gekennzeichnet ist, daß die Getriebeausgänge jeweils einzeln durch eine Umschaltvorrichtung mit der Antriebswelle koppelbar sind. Ein Vorteil besteht darin, daß in einfacher Weise ein motorischer Antrieb für die Stellglieder ermöglicht wird.

Durch geeignete elektrische Ansteuerung von außen kann der Antriebsmotor mehr oder weniger lang in Betrieb gesetzt werden und treibt somit einen der Getriebeausgänge an, der gerade durch die Umschaltvorrichtung mit dem Antriebsmotor gekoppelt ist. Es ist denkbar, bei geeigneter Konstruktion der Umschaltvorrichtung diese durch entsprechende Betätigung des Antriebsmotors ebenfalls zu betätigen oder den Antriebsmotor mittels elektrisch betätigter Kupplungen wahlweise mit dem Getriebe oder der Umschaltvorrichtung zu koppeln. Vorzugsweise ist jedoch zur Betätigung der Umschaltvorrichtung ein weiterer elektrischer Motor vorgesehen.

Wenn sich die Umschaltvorrichtung im Streufeld eines Kernresonanzspektrometers oder allgemein einer Vorrichtung befindet, deren Magnetfeld nicht übermäßig gestört werden soll, so ist es zweckmäßig, den Stellantrieb weitestmöglich aus nichtmagnetischem Material herzustellen, beispielsweise metallische Teile unter Verwendung von Aluminium herzustellen. Die genannten elektrischen Motoren enthalten magnetisches Material, was aber bei Vorhandensein von lediglich zwei elektrischen Motoren bei Versuchen nicht zu einer merklichen Störung des Magnetfelds am Ort einer zu untersuchenden Probe innerhalb eines Kernresonanzspektrometers geführt hat, weil der Einfluß dieser Motoren auf die Homogenität des Magnetfelds leicht kompensiert werden kann und weil Messungen an Proben nur bei stillstehenden Motoren ausgeführt werden. Die weitgehende Verwendung von nichtmagnetischem Material ermöglicht auf einfache Weise den sicheren Betrieb des Stellantriebs auch im extrem starken Streufeld von Hochfeldmagneten für Kernresonanzspektrometer. Der Betrieb der elektrischen Motoren selbst wird durch das Magnetfeld nicht störend beeinflußt.

Bei einer Ausführungsform der Erfindung ist vorgesehen, daß die Umschaltvorrichtung ein drehbar gelagertes Rad aufweist, dessen Lagerung verschiebbar geführt ist und das in Abhängigkeit von dem Ort seiner Lagerung ein mit einem der Getriebeausgänge fest verbundenes Rad mit einem mit dem Antriebsmotor fest gekoppelten Rad koppelt. Dies ermöglicht eine einfache Konstruktion.

Bei einer Ausführungsform der Erfindung ist vorgesehen, daß das Rad der Umschaltvorrichtung quer zu seiner Drehachse verschiebbar gelagert ist. Dies ermöglicht auf einfache Weise ein sicheres Umschalten, da das Rad der Umschaltvorrichtung bei seiner Verschiebung abrollen kann.

Bei einer Ausführungsform der Erfindung ist vorgesehen, daß das Rad der Umschaltvorrichtung die durch dieses miteinander gekoppelten Räder mit dem selben Umfangsbereich berührt. Ein Vorteil besteht darin, daß bei stillstehender Antriebsseite durch das Abrollen des Rads der Umschaltvorrichtung keine unerwünschte Verstellung der Getriebeausgänge erfolgen kann.

Bei einer Ausführungsform der Erfindung ist vorgesehen, daß eine der Anzahl der Getriebeausgänge entsprechende Anzahl von Rädern vorgesehen ist, die mit parallelen Achsen in einer Reihe nebeneinander angeordnet sind und daß das Rad der Umschaltvorrichtung linear verschiebbar gelagert ist, derart, daß es mit den genannten Rädern einzeln in Eingriff bringbar ist. Ein Vorteil besteht in der einfachen Konstruktion und darin, daß diese Anordnung ohne größere Änderungen für eine beliebige Zahl von Getriebeausgängen bzw. Stellgliedern verwendbar ist, wobei nur die Anzahl der genannten Räder zu verändern ist und sich die Länge des Verschiebewegs der genannten Lagerung in der Umschaltvorrichtung entsprechend ändert.

Um das Rad der Umschaltvorrichtung in jeder möglichen Stellung der Umschaltvorrichtung antreiben zu können, kann erfindungs-gemäß ein vom Antriebsmotor angetriebener Riemen, insbesondere ein Zahnriemen, vorgesehen sein, auf dem das genannte Rad bei der Betätigung der Umschaltvorrichtung abrollt und mit dem es ständig in Eingriff ist. Um die unten beschriebene Rutschkupplung zu verwirklichen, kann dabei die dem Rad zugewandte Seite des Zahnriemens, im allgemeinen seine Außenseite, glatt sein.

Bei einer anderen Ausführungsform der Erfindung ist vorgesehen, daß mit dem Antriebsmotor eine Reihe von miteinander in Eingriff befindlichen Zahnrädern gekoppelt ist, die mit je einem einem Getriebeausgang zugeordneten Rad fluchten, wobei die Umschaltvorrichtung je zwei miteinander fluchtende Räder verbindet. Ein Vorteil besteht in der einfachen Konstruktion. Falls erforderlich, kann der Einfluß von Spiel zwischen miteinander in Eingriff befindlichen Zahnrädern dadurch verringert werden, daß man den Antriebsmotor nicht, wie beim Ausführungsbeispiel, mit dem letzten Zahnrad in der Reihe unmittelbar koppelt, sondern mit einem zur Mitte der Reihe hin gelegenen Zahnrad.

Bei einer Ausführungsform der Erfindung ist vorgesehen, daß das Rad der Umschaltvorrichtung als Reibrad ausgebildet ist. Ein Vorteil besteht darin, daß hierdurch eine Rutschkupplung gebildet wird, die zum Schutz der ganzen Anordnung dienen kann.

Bei einer Ausführungsform der Erfindung ist vorgesehen, daß Stellungsgeber für die Stellung der Getriebeausgänge vorgesehen sind. Ein Vorteil besteht darin, daß hierdurch der ferngesteuerte Betrieb oder der automatische Betrieb erleichtert wird. Die Stellungsgeber können Inkrementgeber sein; zweckmäßig sind aber auch Absolutwertgeber, die es auf einfachere Weise ermöglichen, automatisch eine vorbestimmte Ausgangsstellung des Getriebes einzustellen.

Bei einer Ausführungsform der Erfindung ist vorgesehen, daß Stellungsgeber für die Stellung des Antriebsmotors und/oder des weiteren Motors vorgesehen sind. Ein Vorteil besteht darin, daß im Zusammenwirken mit den Stellungsgebern für die Getriebeausgänge ein Spiel in der Vorrichtung sehr genau daran erkannt werden kann, daß der Antriebsmotor schon läuft, wogegen am Getriebeausgang noch keine Bewegung auftritt. Dadurch kann der Einfluß von Spiel berücksichtigt werden. Ein Blockieren kann durch Erfassen der in einem solchen Fall stark ansteigenden Stromaufnahme des Motors erkannt werden.

Bei einer Ausführungsform der Erfindung ist vorgesehen, daß die Getriebeausgänge mit vorzugsweise beliebig orientierbaren Bewegungsübertragungselementen wie Gelenkwellen, ausziehbaren Wellen, biegsamen Wellen, und/oder längenveränderlichen Wellen, Kabelzügen verbunden sind, deren andere Enden mit den zu betätigenden Stellgliedern verbindbar sind. Ein Vorteil besteht darin, daß ein leichtes Ankoppeln an die Stellglieder möglich ist.

Bei einer Ausführungsform der Erfindung ist vorgesehen, daß Enden der Bewegungsübertragungselemente in einer an einem ortsfesten Teil zu befestigenden Kopplungsvorrichtung gehalten sind. Ein Vorteil besteht darin, daß die Ankopplung erleichtert ist und Fehler beim Ankoppeln leicht vermieden werden können.

Bei einer Ausführungsform der Erfindung ist vorgesehen, daß in der Kopplungsvorrichtung ein Gewindetrieb zum Umwandeln einer Drehbewegung eines Getriebeausgangs in eine Verschiebebewegung angeordnet ist. Ein Vorteil besteht darin, daß auf einfache Weise Stellglieder, die als Schiebestangen ausgebildet sind, betätigbar sind.

Bei einer Ausführungsform der Erfindung ist vorgesehen, daß der Stellantrieb eine Elektronik zum Auswerten von von außen kommenden Steuersignalen aufweist. Hierdurch wird eine Fernsteuerung und ein automatischer Betrieb erleichtert. Die Elektronik kann zweckmäßig zum Ausgeben von Signalen über den Schaltzustand des Stellantriebs ausgebildet sein.

Weitere Merkmale und Vorteile der Erfindung ergeben sich aus der nachfolgenden Beschreibung eines Ausführungsbeispiels der Erfindung anhand der Zeichnung, die erfindungswesentliche Einzelheiten zeigt, und aus den Ansprüchen. Die einzelnen Merkmale können je einzeln für sich oder zu mehreren in beliebiger Kombination bei Ausführungsformen der Erfindung verwirklicht sein. Es zeigen:
- Fig. 1: eine oben abgebrochene Vorderansicht eines Stellantriebs, wobei zahlreiche Teile in einem Schnitt entsprechend der Linie I - I in Fig. 3 gezeigt sind und die in Fig. 2 gezeigten Teile zur Vereinfachung fortgelassen sind,
- Fig. 2: einen Schnitt entsprechend der Linie II - II in Fig. 1,
- Fig. 3: eine Darstellung, die im wesentlichen einen Schnitt entsprechend der Linie III - III in Fig. 1 ist,
- Fig. 4: die Fortsetzung nach oben der im oberen Bereich abgebrochenen Fig. 1,
- Fig. 5: eine Einzelheit der Fig. 4 in einem rechtwinklig zur Ebene der Fig. 4 verlaufenden Schnitt,
- Fig. 6: das Prinzipschaltbild einer elektronischen Schaltung.

In den Figuren sind lediglich die zum Verständnis der Erfindung wesentlichen Teile eingezeichnet; dagegen sind beispielsweise die Lagerungen der verschiedenen drehbaren Teile nur in Einzelfällen dargestellt.

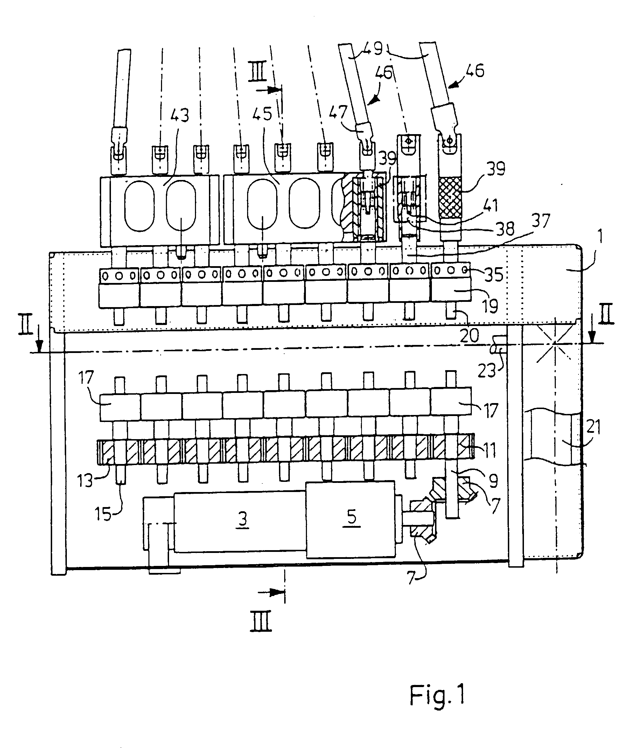

In Fig. 1 ist in einem Gehäuse 1 ein elektrischer Antriebsmotor 3, dem ein Untersetzungsgetriebe 5 mit dem Untersetzungsverhältnis 30:1 nachgeschaltet ist, über Kegelräder 7 mit einer Welle 9 verbunden, auf der ein Zahnrad 11 sitzt. Es sind weitere acht gleiche Zahnräder 13 vorgesehen, die mit parallelen Achsen, die alle in einer einzigen Ebene parallel zur Zeichenebene der Fig. 1 liegen, angeordnet sind und die miteinander im Eingriff sind. Wenn sich somit das Zahnrad 11 dreht, dreht sich das mit diesem unmittelbar in Eingriff befindliche Zahnrad 13 im Gegensinn, das nächste Zahnrad 13 im gleichen Drehsinn wie das Zahnrad 11 und so fort. Auch die Zahnräder 13 sitzen jeweils auf einer Welle 15, die im Gehäuse 1 drehbar gelagert ist, und auf der dem Antriebsmotor 3 abgewandten Seite der Zahnräder 11 und 13 ist auf deren Welle 15 jeweils ein Reibrad 17 aus Metall drehfest angeordnet, wobei der Durchmesser der Reibräder 17 geringfügig kleiner ist als der Abstand von Mitte zu Mitte der einzelnen Zahnräder 11 und 13. Die Reibräder 17 sind alle gleich groß.

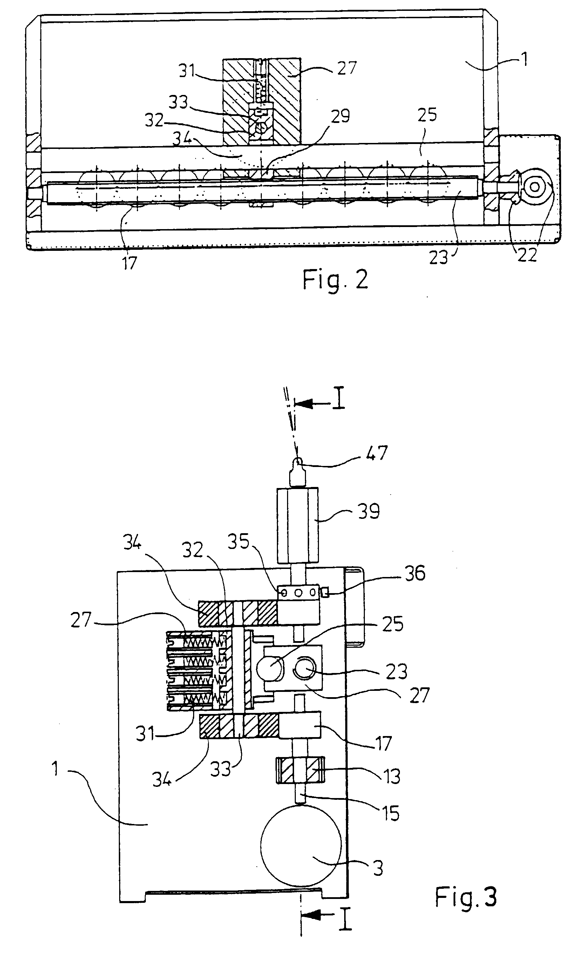

Gleichachsig mit den Wellen der Zahnräder 11 und 13 sind im Gehäuse 1 neun weitere Reibräder 19 auf Wellen 20 drehbar gelagert; der Durchmesser dieser Reibräder ist gleich dem der Reibräder 17. Die Konstruktion ist so gewählt, daß bei laufendem Antriebsmotor 3, wodurch alle Reibräder 17 in Drehung versetzt werden, genau eines der weiteren Reibräder 19 angetrieben werden kann, und zwar in Abhängigkeit davon, in welcher Schaltstellung sich eine Umschaltvorrichtung befindet. Diese Umschaltvorrichtung weist einen elektrischen Motor 21 auf, der eine in Fig. 1 lediglich abgebrochen dargestellte, und im übrigen in Fig. 2 gezeigte Gewindespindel 23 über Kegelräder 22 antreibt. Die Längsachse des Motors 21 verläuft rechtwinklig zur Längsachse des Antriebssmotors 3. Parallel zur Gewindespindel 23 verläuft eine Führungsstange 25, auf der ein Gleitstück 27 verschiebbar geführt ist, das eine Mutter 29 aufweist, in die die Gewindespindel 23 eingreift. Somit wird dann, wenn die Gewindespindel 23 durch den Motor 21 gedreht wird, das Gleitstück 27 verschoben. Im Gleitstück 27 ist in einem über Druckfedern 31 abgestützten Lagerbock 32, der im Gleitstück 27 rechtwinklig zur Längsachse der Gewindespindel 23 verschiebbar geführt ist, eine Welle 33 drehbar gelagert, auf deren beiden Enden gleich große Reibräder 34 drehfest befestigt und somit durch die Welle 33 drehfest miteinander verbunden sind. Diese Reibräder 34 bestehen aus einem Kunststoff, der im Zusammenwirken mit dem Metall der Reibräder 17 und 19 einen ausreichend hohen Reibungskoeffizienten aufweist. Der Abstand der beiden Reibräder 34 ist so groß und sie sind derart angeordnet, daß eines der Reibräder 34 mit einem der Reibräder 17 und das andere der Reibräder 34 mit einem der Reibräder 19 in Eingriff ist. Die Druckfedern 31 bewirken dabei eine ausreichend feste Anlage der einzelnen Reibräder derart, daß eine sichere Bewegungsübertragung möglich ist, ohne jedoch im Falle einer Blockierung von Teilen eine Zerstörung zu bewirken; im letztgenannten Fall rutscht vielmehr die durch die Reibräder gebildete Rutschkupplung.

An ihrem außerhalb des Bereichs der Reibräder 34 liegenden Bereich tragen die Reibräder 19 an ihrem Umfang verteilt eine Reihe von Reflektoren 35, die zusammen mit einem Lichtsender und Lichtempfänger 36 eine Reflektorlichtschranke bilden, durch die mittels einer Elektronik der von dem jeweiligen Reibrad 19 ausgeführte Drehwinkel und seine Stellung ermittelt werden kann. Ähnliche Reflektorlichtschranken oder allgemeiner Drehwinkelgeber und/oder Drehstellungsgeber sind auch am Antriebsmotor und an dem die Schaltvorrichtung antreibenden motor vorgesehen.

Die in Fig. 1 und 3 nach oben aus dem Gehäuse 1 herausragenden Wellen 20 sind zur drehfesten Verbindung mit mechanischen Ankoppelelementen, sogenannten Steckwellen 39 ausgebildet. Hierzu weisen die Enden 37 der Wellen 20 an ihrem oberen Ende eine diagonal verlaufende Nut 38 nach Art eines Schraubenzieherschlitzes einer normalen Schraube auf, in die ein schraubenzieherklingenartiges Teil 41 einer Steckwelle 39 eingreifen kann. Dadurch ist eine leicht lösbare drehsichere Verbindung möglich, wobei deswegen, weil zueinander passende Stellungen um jeweils einen Drehwinkel von 180° voneinander verschieden sind, ein geringfügiges Spiel in der ganzen Anordnung nicht das Zusammenstecken in einer gewünschten vorbestimmten Stellung verhindert. In Fig. 1 ist erkennbar, daß die linken drei Steckwellen durch ein Verbindungsteil 43 und die nächstfolgenden vier Steckwellen durch ein Verbindungsteil 45 parallel und im Abstand voneinander gehalten und verbunden sind, so daß sie auf die freien Enden 37 der Wellen 20 aufgesteckt werden können. Dadurch kann das Montieren und Demontieren rasch erfolgen, außerdem wird die Gefahr von Verwechslungen verhindert. Die beiden rechts liegenden Steckwellen werden im Beispiel jeweils einzeln aufgesteckt.

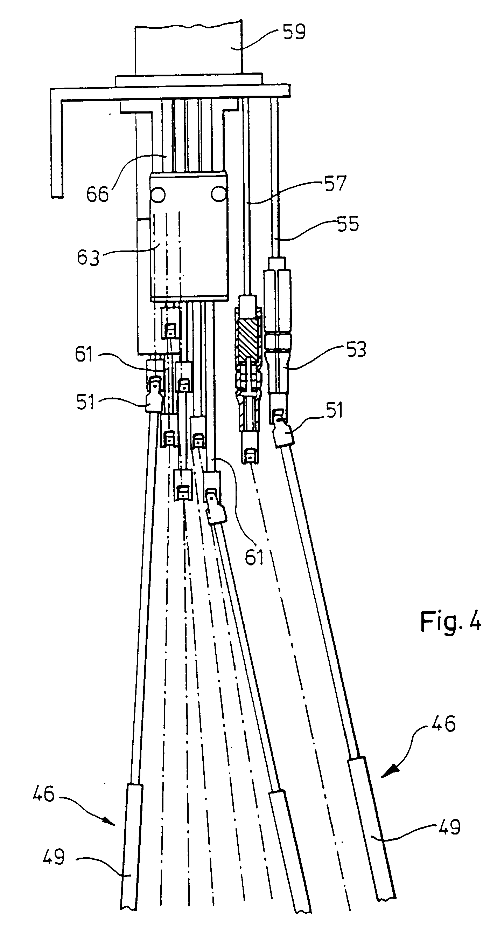

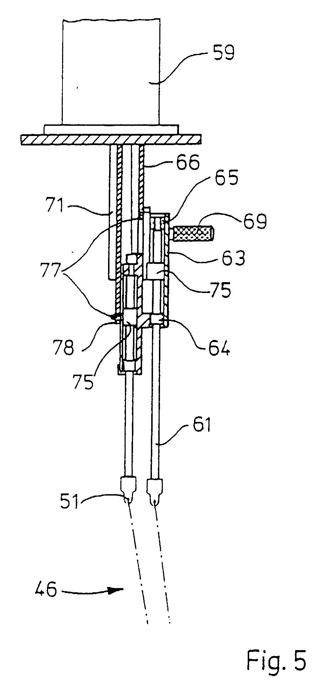

Jede Steckwelle 39 ist Teil einer Kardanwelle 46, die aus der jeweiligen Steckwelle 39, einer mit dieser durch ein erstes Kardangelenk 47 verbundenen ausziehbaren Welle 49, die Drehbewegungen überträgt und daher beispielsweise durch ineinander verschiebbar geführte Vierkantprofile gebildet sein kann, und einem zweiten Kardangelenk 51 besteht, siehe Fig. 4 und 5.

Im Fall der beiden in Fig. 1 und 4 rechts liegenden Kardanwellen 46 ist mit dem zweiten Kardangelenk 51 eine weitere Steckwelle 53 verbunden, die im Betrieb vorzugsweise parallel zu der zugeordneten Steckwelle 39 verläuft, so daß eine Drehbewegung des zugeordneten Reibrads 19 gleichförmig auf die weitere Steckwelle 53 übertragen wird. Die den beiden in Fig. 1 rechts liegenden Kardanwellen zugeordneten weiteren Steckwellen 53 stellen wiederum, wie die Steckwellen 39, eine drehfeste und lösbare Verbindung mit zwei um ihre Längsachse drehbaren Stangen 55 und 57 her, die drehbare Stellglieder eines Probenkopfes 59 sind.

Die in Fig. 1 und 4 links liegenden sieben Kardanwellen treiben über die zweiten Kardangelenke 51 Stangen 61 drehbar an, die im Beispiel jedoch nicht Stellglieder des Probenkopfes sind, sondern es wird die Drehbewegung dieser Stangen 61 mittels einer Schiebetriebanordnung 63 in eine Verschiebebewegung umgesetzt, durch die die eingangs genannten Schiebestangen 66, die die weiteren Stellglieder des hier verwendeten Probenkopfes 59 sind, verschieben. Hierzu ist die mit dem zweiten Kardangelenk 51 in dessen Fortsetzung nach oben verbundene Stange 61 etwa im Bereich ihrer oberen Hälfte als Gewindespindel ausgebildet, die in einem ortsfesten Lager 64, 65 drehbar gelagert ist. Das ortsfeste Lager wird dadurch gebildet, daß die Schiebetriebanordnung 63, in der die Lager 64 und 65 vorgesehen sind, mittels Befestigungsschrauben 69 an einem ortsfesten Teil des Probenkopfes 59, nämlich an dem sogenannten Rastergehäuse 71, das auch zur Führung der Schiebestangen 66 dient, gehalten ist. Auf dem Gewindeteil jeder Stange 61 gleitet eine in einem Gehäuse der Schiebetriebanordnung 63 drehfest aber verschiebbar geführte Mutter 75, die einen dornförmigen Fortsatz 77 aufweist, der in ein bei den bekannten Probenköpfen in der Schiebestange vorhandenes Loch 78 eingreift, das ursprünglich zum Eingriff eines von Hand zu betätigenden Hakens gedacht ist. Je nach Drehrichtung der Stange 61 wird somit der Fortsatz 77 nach oben oder unten verschoben und verschiebt im gleichen Sinn die Schiebestange.

Da die Stangen 61 auch dann, wenn die Schiebetriebanordnung 63 von dem Probenkopf 59 abgekoppelt ist, mit dieser verbunden sind, muß sich beim Drehen einer der Stangen 61 die entsprechende Mutter 75 in der Schiebetriebanordnung 63 verschieben. Daher ist es möglich, auch im abgekoppelten Zustand die Fortsätze 77 durch geeignete Betätigung der beiden Motoren des Stellantriebs in eine vorbestimmte Ausgangsstellung zu bringen, von Hand die Schiebestangen des Probenkopfes ebenfalls in eine dazu passende Ausgangsstellung zu bringen und dann den Stellantrieb mühelos mit den Schiebestangen zu koppeln. Es ist zweckmäßig, daß der Stellantrieb durch einen an ihm selbst angeordneten Schalter, zum Beispiel einen Tastschalter, in die genannte Ausgangsstellung bringbar ist, um den Ankoppelvorgang zu beschleunigen. Wird in dieser Ausgangsstellung abgekoppelt, so befinden sich die Schiebestangen des Probenkopfes im Augenblick des Lösens von dem Stellantriebs bereits in der Stellung, die sie bei der nächsten Verwendung zusammen mit dem Stellantrieb haben müssen.

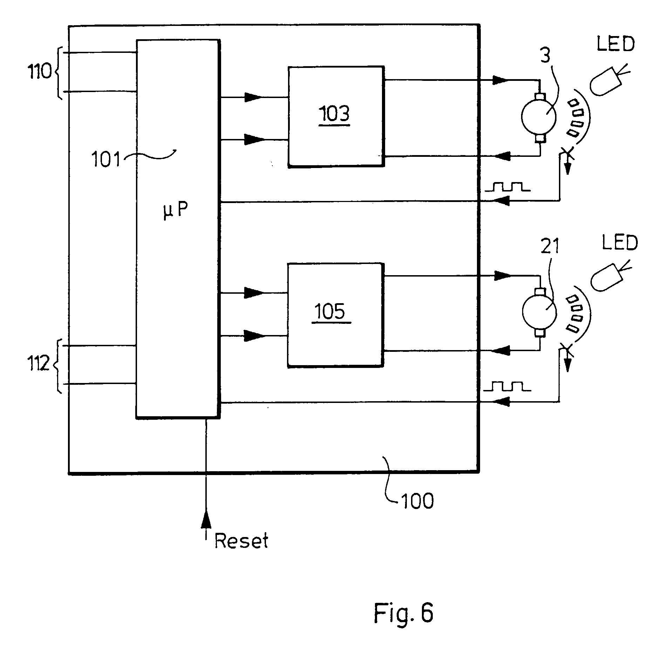

Die in Fig. 6 nur schematisch gezeigte elektronische Schaltung 100 für den Stellantrieb weist einen handelsüblichen integrierten Mikroprozessor zur Steuerung von kleinen Motoren auf. Hierbei handelt es sich um den Mikroprozessor µP 78310 der Firma NEC in Japan. Mit Ausgängen dieser integrierten Schaltung 101 sind zwei Leistungsstufen 103 und 105 verbunden, von denen die erstgenannte den Antriebsmotor 3 und die letztgenannte den weiteren Motor 21 ansteuert. Diese beiden Motoren sind mit Reflexlichtschranken ausgestattet, deren Signale ebenfalls der integrierten Schaltung 101 zugeführt werden. Einige Eingänge 110 der integrierten Schaltung 101 sind zur Eingabe von analogen Eingangssignalen vorgesehen, weitere Anschlüsse 112 bilden einen üblichen seriellen Kanal zur Eingabe und Ausgabe von Daten.

Die oben genannte Ausgangsstellung des Stellantriebs und eines Probenkopfes dient, wie erwähnt, zum Zusammenkoppeln und zum Trennen dieser Teile. Bei dem Wechsel eines Probenkopfes oder beim Wechseln der aufzunehmenden Kernresonanzfrequenz ist normalerweise recht genau bekannt, wie die Stellglieder eingestellt werden müssen, damit anschließend nur noch eine Feinkorrektur anhand der Messung der komplexen Impedanz des Probenkopfes nötig ist. Somit wird der Stellantrieb zunächst automatisch auf die dem Computer des Kernresonanzspektrometers bekannten Einstellwerte eingestellt, was sehr rasch erfolgen kann. Die Feinkorrektur erfordert dann ebenfalls nicht viel Zeit.

Damit der Computer die Tätigkeit des Stellantriebs überwachen kann, gibt die Elektronik 100 folgende Daten aus: Stellung der Umschaltvorrichtung; Anzahl von Drehschritten, die von den Motoren nach links bzw. rechts ausgeführt wurden; zwangsweiser Stillstand eines Motors infolge einer Störung (Blockieren) oder weil ein Endanschlag erreicht wurde; Stellung der einzelnen Getriebeausgänge; der Stellantrieb hat die zum An- und Abkoppeln benötigte Ausgangsstellung erreicht.

Der Computer gibt folgende Informationen an den Stellantrieb: einen bestimmten Getriebeausgang mit dem Antriebsmotor koppeln; Linksdrehen oder Rechtsdrehen des Antriebsmotors um eine bestimmte Anzahl von Schritten; Ausgangsstellung annehmen (das heißt, einen Resetvorgang ausführen).

Wird ein Blockieren eines Motors infolge einer Störung erkannt, so polt die Elektronik versuchsweise den Motor um, damit er im entgegengesetzten Drehsinn läuft und versucht anschließend, den ursprünglich vorgesehenen Einstellvorgang erneut auszuführen.

Alle Teile des Stellantriebs mit Ausnahme der Motoren und der Reibräder 37, die aus Kunststoff bestehen, bestehen aus nichtmagnetischem Metall, nämlich aus Aluminium.

Im Beispiel haben die Motoren eine Betriebsspannung von 24 Volt; der Arbeitsstrom des Antriebsmotors beträgt maximal 0,8 A, der des Motors der Umschaltvorrichtung maximal 0,2 A.

Bei dem Probenkopf kann es sich z. B. um den Typ Z 3149 der Firma Spectrospin AG, CH-8117 Fällanden, Schweiz, handeln, der für die Spektren folgender Kernarten geeignet ist: ¹H, ³¹P, ³⁷Rb, ¹³C, ²H, ¹⁷O, ¹⁵N, ¹⁴N, ⁹⁷Mo, ¹⁰⁹Ag.

Im Beispiel entspricht die Ausgangsstellung der Stellung Null für alle Schiebestangen. Für die drehbaren Stellglieder ist keine Ausgangsstellung vorgesehen.

Wichtig bei der Erfindung ist noch, daß der Stellantrieb leicht für bereits vorhandene Probenköpfe eingesetzt werden kann und daß das Ankoppeln einfach ist. Ein einziger Stellantrieb kann bei einer Vielzahl unterschiedlicher Probenköpfe verwendet werden.

## Patentansprüche

1. Stellantrieb zum steuerbaren Verstellen einer Mehrzahl von Stellgliedern in einem Kernresonanzspektrometer, wobei der Stellantrieb ein Getriebe mit einer durch einen elektrischen Antriebsmotor (3) antreibbaren Antriebswelle (9) und mit einer Mehrzahl von mit den Stellgliedern zu koppelnden Getriebeausgängen aufweist und dadurch gekennzeichnet ist, daß die Getriebeausgänge jeweils einzeln durch eine Umschaltvorrichtung mit der Antriebswelle koppelbar sind.

2. Stellantrieb nach Anspruch 1, dadurch gekennzeichnet, daß die Umschaltvorrichtung von einem weiteren elektrischen Motor (21) angetrieben ist.

3. Stellantrieb nach einem der vorhergehenden Ansprüche, dadurch gekennzeichnet, daß die Umschaltvorrichtung ein drehbar gelagertes Rad (34) aufweist, dessen Lagerung verschiebbar geführt ist und das in Abhängigkeit von dem Ort seiner Lagerung ein mit einem der Getriebeausgänge fest verbundenes Rad (19) mit einem mit dem Antriebsmotor fest gekoppelten Rad (17) koppelt.

4. Stellantrieb nach Anspruch 3, dadurch gekennzeichnet, daß das Rad (34) der Umschaltvorrichtung quer zu seiner Drehachse verschiebbar gelagert ist.

5. Stellantrieb nach Anspruch 3 oder 4, dadurch gekennzeichnet, daß das Rad (34) der Umschaltvorrichtung die durch dieses miteinander gekoppelten Räder (17, 19) mit dem selben Umfangsbereich berührt.

6. Stellantrieb nach einem der vorhergehenden Ansprüche, dadurch gekennzeichnet, daß eine der Anzahl der Getriebeausgänge entsprechende Anzahl von Rädern (17) vorgesehen ist, die mit parallelen Achsen in einer Reihe nebeneinander angeordnet sind und daß das Rad (34) der Umschaltvorrichtung linear verschiebbar gelagert ist, derart, daß es mit den genannten Rädern (17) einzeln in Eingriff bringbar ist.

7. Stellantrieb nach einem der vorhergehenden Ansprüche, dadurch gekennzeichnet, daß mit dem Antriebsmotor (3) eine Reihe von miteinander in Eingriff befindlichen Zahnrädern (11, 13) gekoppelt ist.

8. Stellantrieb nach einem der Ansprüche 3 bis 7, dadurch gekennzeichnet, daß das Rad (34) der Umschaltvorrichtung als Reibrad ausgebildet ist.

9. Stellantrieb nach einem der vorhergehenden Ansprüche, dadurch gekennzeichnet, daß Stellungsgeber für die Stellung der Getriebeausgänge vorgesehen sind.

10. Stellantrieb nach einem der vorhergehenden Ansprüche, dadurch gekennzeichnet, daß Stellungsgeber für die Stellung des Antriebsmotors (3) und/oder des weiteren Motors (21) vorgesehen sind.

11. Stellantrieb nach einem der vorhergehenden Ansprüche, dadurch gekennzeichnet, daß die Getriebeausgänge mit vorzugsweise beliebig orientierbaren Bewegungsübertragungselementen wie Gelenkwellen (46), ausziehbaren Wellen (49), biegsamen Wellen, Kabelzügen verbunden sind, deren andere Enden mit den zu betätigenden Stellgliedern verbindbar sind.

12. Stellantrieb nach Anspruch 11, dadurch gekennzeichnet, daß Enden der Bewegungsübertragungselemente in einer an einem ortsfesten Teil zu befestigenden Kopplungsvorrichtung gehalten sind.

13. Stellantrieb nach Anspruch 12, dadurch gekennzeichnet, daß in der Kopplungsvorrichtung ein Gewindetrieb (61, 75) zum Umwandeln einer Drehbewegung eines Getriebeausgangs in eine Verschiebebewegung angeordnet ist.

14. Stellantrieb nach einem der Ansprüche 11 bis 13, dadurch gekennzeichnet, daß Enden mehrerer Bewegungsübertragungselemente durch ein Verbindungsteil (43, 63) in einer vorbestimmten gegenseitigen Lage gehalten sind, die ein rasches Verbinden mit anderen Teilen, z.B. Wellen 46, oder Schiebestangen 66, ermöglicht.

## Claims

1. Actuating drive for controllable adjustment of a plurality of actuators in a nuclear resonance spectrometer, wherein the actuating drive has a drive train with a drive shaft (9) that can be driven by an electric drive motor (3) and with a plurality of drive train outputs, for coupling to the actuators,
characterized in that
the drive train outputs can each be individually coupled to the drive shaft by means of a changeover device.

2. Actuating drive according to claim 1, characterized in that a further electric motor (21) is provided to actuate the changeover device.

3. Actuating drive according to one of the preceding claims, characterized in that the changeover device has a rotatably mounted wheel (34) whose mount is displaceably guided, and which, depending on the position of its mount, couples a wheel (19) integrally joined to the drive train output with a wheel (17) integrally coupled to the drive motor.

4. Actuating drive according to claim 3, characterized in that the wheel (34) of the changeover device is mounted for displacement perpendicular to its axis of rotation.

5. Actuating drive according to claim 3 or 4,
characterized in that the wheel (34) of the changeover device contacts the wheels (17, 19) coupled together thereby at the same circumferential region.

6. Actuating drive according to one of the preceding claims, characterized in that a number of wheels (18) corresponding to the number of drive train outputs is provided, with the wheels being arranged with parallel axes in a row next to one another, and the wheel (34) of the changeover device is mounted for linear displacement, so that it can be individually brought into engagement with the said wheels (17).

7. Actuating drive according to one of the preceding claims, characterized in that a row of gears (11, 13), in mutual engagement, is coupled to the drive motor (3).

8. Actuating drive according to one of the claims 3 through 7, characterized in that the wheel (34) of the changeover device is designed as a friction wheel.

9. Actuating drive according to one of the preceding claims, characterized in that position transducers for the position of the drive train output are provided.

10. Actuating drive according to one of the preceding claims, characterized in that position transducers for the position of at least one motor (3, 21) are provided.

11. Actuating drive according to one of the preceding claims, characterized in that the drive trains outputs are preferentially connected to motion transmission elements, which can be oriented in an arbitrary fashion such as cardan shafts (46), extendable shafts (49), flexible shafts, cable connectors, the other ends of which can be connected to the actuators being actuated.

12. Actuating drive according to claim 11, characterized in that ends of the motion transmission elements are retained in a coupling device to be fastened to a stationary part.

13. Actuating drive according to claim 12, characterized in that a screw drive (61, 75), to convert a rotary motion of a drive train output into a displacement motion, is arranged in the coupling device.

14. Actuating drive according to the claims 11 through 13, characterized in that ends of a plurality of motion transmission elements are retained in a predetermined position relative one to the other by an interconnecting element (43, 63), for enabling them to be rapidly connected to other elements, for example, shafts 46 or slide rods 66.

## Revendications

1. Servo-entraînement pour la manoeuvre asservissable d'une pluralité d'organes de réglage dans un spectromètre de résonance magnétique nucléaire, le servo-entraînement présentant une transmission avec un arbre d'entraînement (9) pouvant être entraîné par un moteur d'entraînement électrique (3) et avec une pluralité de sorties de transmission à accoupler aux organes de réglage, **caractérisé** en ce que les sorties de transmission peuvent être chacune individuellement accouplées à l'arbre d'entraînement par un dispositif de commutation.

2. Servo-entraînement selon la revendication 1, **caractérisé** en ce que le dispositif de commutation est entraîné par un moteur électrique supplémentaire (21).

3. Servo-entraînement selon l'une des revendications précédentes, **caractérisé** en ce que le dispositif de commutation présente une roue (34) montée à rotation, dont le palier de montage est guidé en translation et qui, en fonction de l'emplacement de son palier de montage, accouple une roue (19) fixement reliée à une des sorties de transmission à une roue (17) fixement accouplée au moteur d'entraînement.

4. Servo-entraînement selon la revendication 3, **caractérisé** en ce que la roue (34) du dispositif de commutation est montée à translation transversalement à son axe de rotation.

5. Servo-entraînement selon la revendication 3 ou 4, **caractérisé** en ce que la roue (34) du dispositif de commutation entre en contact avec les roues (17, 19) qu'elles accouplent l'une à l'autre par la même région circonférentielle.

6. Servo-entraînement selon l'une des revendications précédentes, **caractérisé** en ce qu'il est prévu un nombre de roues (17) correspondant au nombre de sorties de transmission, roues qui sont juxtaposées en une rangée avec des axes parallèles, et en ce que la roue (34) du dispositif de commutation est montée à translation linéaire, de telle sorte qu'elle peut être amenée individuellement en engagement avec les roues précitées (17).

7. Servo-entraînement selon l'une des revendications précédentes, **caractérisé** en ce qu'une rangée de roues dentées (11, 13) en prise mutuelle est accouplée au moteur d'entraînement (3).

8. Servo-entraînement selon l'une des revendications 3 à 7, **caractérisé** en ce que la roue (34) du dispositif de commutation est réalisée sous forme de roue de friction.

9. Servo-entraînement selon l'une des revendications précédentes, **caractérisé** en ce que des transmetteurs de position sont prévus pour la position des sorties de transmission.

10. Servo-entraînement selon l'une des revendications précédentes, **caractérisé** en ce que des transmetteurs de position sont prévus pour la position du moteur d'entraînement (3) et/ou du moteur supplémentaire (21).

11. Servo-entraînement selon l'une des revendications précédentes, **caractérisé** en ce que les sorties de transmission sont reliées à des éléments de transmission de mouvement pouvant de préférence être orientés de façon quelconque, tels que des arbres de transmission (46), des arbres télescopiques (49), des arbres flexibles, des transmissions par câbles, dont les autres extrémités peuvent être reliées aux organes de réglage à actionner.

12. Servo-entraînement selon la revendication 11, **caractérisé** en ce que des extrémités des éléments de transmission de mouvement sont maintenues dans un dispositif d'accouplement à fixer à une pièce stationnaire.

13. Servo-entraînement selon la revendication 12, **caractérisé** en ce qu'une transmission à broche filetée (61, 75) est disposée dans le dispositif d'accouplement pour transformer un mouvement de rotation d'une sortie de transmission en un mouvement de translation.

14. Servo-entraînement selon l'une des revendications 11 à 13, **caractérisé** en ce que des extrémités de plusieurs éléments de transmission de mouvement sont maintenues par une pièce de liaison (43, 63) dans une position mutuelle prédéfinie, qui permet un assemblage rapide avec d'autres pièces, par exemple des arbres (46) ou des barres coulissantes (66).
